# EUROPEAN PATENT APPLICATION

(11) **EP 2 733 725 A1**
(43) Date of publication of application: **21.05.2014**
(21) Application number: 12818349.8
(22) Date of filing: 13.06.2012
(51) Int. Cl.: H01L 21/3065

(54) **DRY ETHCING AGENT**

(30) Priority: 27.07.2011 JP 2011164008
(71) Applicant: CENTRAL GLASS COMPANY, LIMITED, Ube-shi, Yamaguchi 755-0001 (JP)
(72) Inventor: KIKUCHI, Akiou, Yamagucchi 755-0001 (JP); UMEZAKI, Tomonori, Yamagucchi 755-0001 (JP); HIBINO, Yasuo, Saitama 350-1159 (JP); MORI, Isamu, Tokyo 101-0054 (JP); OKAMOTO, Satoru, Saitama 350-1159 (JP)
(74) Representative: Manitz, Finsterwald & Partner GbR
(86) International application number: PCT/JP2012/065074
(87) International publication number: WO 2013/015033

(57) **Abstract**

[Problem] To provide a dry etching agent having little effect on the global environment but having the required performance.

[Solution] Provided is a dry etching agent containing, each at a specific vol%: (A) a fluorine-containing unsaturated hydrocarbon represented by the formula

CₐF_{b}H_{c}

(In the formula, a, b and c are each positive integers and satisfy the correlations of 2≤a≤5, c<b≥1, 2a+2>b+c and b≤a+c, excluding the case where a=3, b=4 or c=2.); (B) at least one kind of gas selected from the group consisting of O₂, O₃, CO, CO₂, COCl₂, COF₂, F₂, NF₃, Cl₂, Br₂, I₂, and YFₙ (where Y is Cl, Br or I and n is an integer of 1 to 5); and (C) at least one kind of gas selected from the group consisting of N₂, He, Ar, Ne, Xe, and Kr.

## Description

### TECHNICAL FIELD

The present invention relates to a dry etching agent comprising a fluorine-containing unsaturated compound and to a dry etching method using the same.

### BACKGROUND OF THE INVENTION

In response to the recent demand for very fine processing techniques in the field of semiconductor manufacturing, dry etching has become mainstream in place of wet processing. Dry etching is a technique for forming a fine pattern on a molecular basis on a material surface by generation of plasma in a vacuum space.

For etching of semiconductor material e.g. silicon dioxide (SiO₂), perfluorocarbon (PFC) and hydrofluorocarbon (HFC) compounds such as CF₄, CHF₃, C₂F₆, C₃F₈ and C₄F₈ have been used as etching agents in order to increase the etching rate of SiO₂ relative to substrate material e.g. silicon, polysilicon or silicon nitride.

However, these PFC and HFC compounds are specified as emission control materials in the Kyoto protocol (COP3) because each of these PFC and HFC compounds has a long atmospheric lifetime and a high global warming potential (GWP). The semiconductor industry thus has a demand for alternative low-GWP materials of high cost efficiency and capable of fine processing.

In view of the above, Patent Document 1 discloses a method of using a reactive gas containing a C₄-C₇ perfluoroketone as a cleaning gas or etching gas in place of the PFC and HFC compounds. This reactive gas is, however, not always favorable as the etching gas due to the fact that, when the perfluoroketone gets decomposed, the resulting decomposition product contains a considerable amount of high-GWP PFC compound and relatively high-boiling substances.

Patent Document 2 discloses a method of using a C₂-C₆ hydrofluoroether as a dry etching gas. However, the C₂-C₆ hydrofluoroether is generally high in GWP and is not favorable in terms of global environmental perspective as in the case of Patent Document 1.

On the other hand, there has been a demand to develop lower-GWP compounds industrially easy to produce. In particular, it has been examined to apply unsaturated fluorocarbons having a double or triple bond in their respective molecules for etching process. As a technique relevant to such application, Patent Document 3 discloses a method for controlling a substrate to be subjected to etching to a temperature of not higher than 50°C while using a saturated or unsaturated higher order chain fluorocarbon compound as an etching gas, and additionally, Patent Document 4 discloses a method of etching a Si film, a SiO₂ film, a Si₃N₄ film or a high-melting metal silicide film with the use of an ether such as CₐF₂ₐ₊₁OCF=CF₂ or a fluorinated olefin such as CF₃CF=CFH or CF₃CH=CF₂.

Further, Patent Document 5 discloses a plasma etching method characterized by using hexafluoro-2-butyne, hexafluoro-1,3-butadiene, hexafluoropropene or the like as an etching gas. Patent Document 6 discloses a method of etching an oxide layer formed on a non-oxide layer e.g. nitride layer with the use of a mixed gas containing (a) an unsaturated fluorocarbon selected from the group consisting of hexafluorobutadiene, octafluoropentadiene, pentafluoropropene and trifluoropropyne, (b) a hydrofluoro methane such as monofluoromethane or difluoromethane and (c) an inert carrier gas.

Furthermore, Patent Document 7 discloses an example where a fluorocarbon not containing hydrogen such as CF₄ and C₄F₆ or a hydrofluorocarbon gas such as C₂HF₅, CH₃F and C₃HF₅ is used, as an etching method for a low-k dielectric material (a dielectric material having a low relative dielectric constant).

In addition, Non-Patent Document 1 discloses the use of a straight-chain unsaturated compound such as hexafluoropropene or hexafluorobutadiene for etching of silicon oxide-based material layer.

### REFERENCES ABOUT PRIOR ART

### Patent Documents

Patent Document 1: Japanese Patent Application Publication No. 2004-536448
Patent Document 2: apanese Patent Application Publication No. H10-140151
Patent Document 3: Japanese Patent Application Publication No. H04-346427
Patent Document 4: Japanese Patent Application Publication No. H10-223614
Patent Document 5: Japanese Patent Application Publication No. H09-191002
Patent Document 6: Japanese Patent Application Publication No. 2002-530863
Patent Document 7: Japanese Patent Application Publication No. 2007-537602

### Non-Patent Document

Non-Patent Document 1: J. Appl. Phys. Vol. 42, pp. 5759-5764, 2003

### SUMMARY OF THE INVENTION

### Problems to be Solved by the Invention

The PFC and HFC compounds are specified as emission control materials because of their high GWP. Although the perfluoroketone, hydrofluoro ether and hydrofluoro vinyl ether are known as alternatives to the PFC and HFC compounds, these alternative compounds have the problems that: when the alternative compound gets decomposed, the resulting decomposition product contains a considerable amount of high-GWP PFC compound; and the alternative compound is not easy to produce and is not economical. There has thus been a demand to develop a dry etching agent having not only less effect on the global environment but also performance required.

As to etching performance, plasma etching allows e.g. isotropic etching of SiO₂ by generation of F radicals from CF₄ gas. In dry etching where fine processing is required, however, it is desirable to use an etching agent having directivity in anisotropic etching rather than in isotopic etching. It is further demanded that the etching agent has less effect on the global environment as well as high cost efficiency.

Any of the techniques using the conventional etching gases requires complicated process and equipment, limited temperature conditions and operations such as application of vibration to the substrate and gas as in the case of Patent Document 5 and thus presents the problem of a narrow process window.

It is accordingly an object of the present invention to provide a dry etching agent capable of securing a wide process window and obtaining a good processing shape without the use of any special equipment by optimization of gas molecular structure and gas composition. It is also an object of the present invention to provide a dry etching method using such a dry etching agent.

### Means for Solving the Problems

As a result of extensive researches, the present inventors have found that a good processing shape can be obtained by performing etching with the use of a dry etching agent containing, each at a specific vol%: (A) a fluorine-containing unsaturated hydrocarbon represented by the formula [1]; (B) at least one kind of gas selected from the group consisting of O₂, O₃, CO, CO₂, COCl₂, COF₂, F₂, NF₃, Cl₂, Br₂, I₂, and YFₙ (where Y is Cl, Br or I and n is an integer of 1 to 5); and (C) at least one kind of gas selected from the group consisting of N₂, He, Ar, Ne, Xe, and Kr, thereby having completed the present invention.

CₐF_{b}H_{c} [1]

(In the formula [1], a, b and c are each positive integers and satisfy the correlations of 2≤a≤5, c<b≥1, 2a+2>b+c and b≤a+c, excluding the case where a=3, b=4 or c=2.)

Namely, the present invention involves [Invention 1] to [Invention 7] as set forth below.

### [Invention 1]

A dry etching agent comprising:
(A) a fluorine-containing unsaturated hydrocarbon represented by the formula [1]

   CₐF_{b}H_{c} [1]

   (In the formula [1], a, b and c are each positive integers and satisfy the correlations of 2≤a≤5, c<b≥1, 2a+2>b+c and b≤a+c, excluding the case where a=3, b=4 or c=2.);
(B) at least one kind of gas selected from the group consisting of O₂, O₃, CO, CO₂, COCl₂, COF₂, F₂, NF₃, Cl₂, Br₂, I₂, and YFₙ (where Y is Cl, Br or I and n is an integer of 1 to 5); and
(C) at least one kind of gas selected from the group consisting of N₂, He, Ar, Ne, Xe, and Kr,
wherein volume percentages of (A), (B) and (C) are 5-40 %, 5-40 % and 20-90 %, respectively (where the total of each of the volume percentages is 100%).

### [Invention 2]

A dry etching agent as discussed in Invention 1, wherein the fluorine-containing unsaturated hydrocarbon is 1,2,3,3,3-pentafluoropropene or 1,1,3,3,3-pentafluoropropene.

### [Invention 3]

A dry etching agent as discussed in Invention 1 or 2, wherein the reducing gas further comprises at least one kind of gas selected from the group consisting of H₂, CH₄, C₂H₂, C₂H₄, C₂H₆, C₃H₄, C₃H₆, C₃H₈, HF, HI, HBr, HCl, CO, NO and NH₃.

### [Invention 4]

A dry etching agent as discussed in any of Inventions 1 to 3, further comprising at least one kind of gas selected from the group consisting of CF₄, CF₃H, CF₂H₂, CFH₃, C₂F₆, C₂F₄H₂, C₂F₅H, C₃F₈, C₃F₇H, C₃F₆H₂, C₃F₅H₃, C₃F₄H₄, C₃F₃H₅, C₃F₅H, C₃F₃H, C₃ClF₃H, C₄F₈, C₄F₆, C₅F₈ and C₅F₁₀.

### [Invention 5]

A dry etching method for selectively etching at least one kind of silicon-based material selected from the group consisting of silicon dioxide, silicon nitride, polycrystalline silicon, amorphous silicon and silicon carbide, comprising the steps of:
generating a plasma gas from a dry etching agent as discussed in any of Inventions 1 to 4; and
using the plasma gas.

### [Invention 6]

A dry etching method for selectively etching at least one kind of silicon-based material selected from the group consisting of silicon dioxide, silicon nitride, polycrystalline silicon, amorphous silicon and silicon carbide, comprising the steps of:
using (A) 1,2,3,3,3-pentafluoropropene, (B) at least one or more kinds of gas selected from the group consisting of H₂, O₂, CO and COF₂, and Ar,
wherein (A), (B) and Ar are fed at volumetric flow rate ratios of 5-40 %, 5-40 % and 20-90 %, respectively (where the total of each of the volumetric flow rate ratios is 100 %).

### [Invention 7]

A dry etching method for selectively etching at least one kind of silicon-based material selected from the group consisting of silicon dioxide, silicon nitride, polycrystalline silicon, amorphous silicon and silicon carbide, comprising the steps of:
using (A) 1,1,3,3,3-pentafluoropropene, (B) at least one or more kinds of gas selected from the group consisting of H₂, O₂, CO and COF₂, and Ar,
wherein (A), (B) and Ar are fed at volumetric flow rate ratios of 5-40 %, 5-40 % and 20-90 %, respectively (where the total of each of the volumetric flow rate ratios is 100 %).

It is already known that 1,1,1,2,3-pentafluoropropene, hexafluoro-2-butyne, hexafluoro-1,3-butadiene, hexafluoropropene etc. are usable as etching gases as mentioned above. The use of such fluorine-containing unsaturated hydrocarbons appears to be favorable because each of them contains a plurality of fluorine atoms in itself and shows a high etching rate against silicon oxide-based material.

Although 1,2,3,3,3-pentafluoropropene or 1,1,3,3,3-pentafluoropropene, which is the target compound of the present invention, is disclosed in Patent Documents 3 and 4, it has been quite unknown whether the target compound of the present invention has a certain extent of the selectivity and a sufficient etching rate against various materials for use in industrial applications.

In view of the above, the present inventors found it is possible to efficiently etch the silicon-based material layer with a high selectivity and a high etching rate by performing etching with the use of a fluorine-containing unsaturated hydrocarbon in the coexistence of an additive gas (such as O₂ and F₂) and an inert gas (such as He and Ar) and by feeding the additive gas in a specific amount.

### EFFECTS OF THE INVENTION

The dry etching gas according to the present invention has a single unsaturated double bond in the molecule and shows a high degradability by OH radials etc. in air and a much smaller contribution to the global warming than PFC and HFC compounds such as CF₄ and CF₃H. There is thus less effect caused on the global environment by using the dry etching gas according to the present invention.

Furthermore, by adding oxidizing gas e.g. oxygen-containing gas or halogen-containing gas or reducing gas to the etching agent, it becomes possible to obtain a significant improvement in process window and address processing requirements such as low side etching ratio and high aspect ratio even without any special substrate excitation operation.

In this way, the dry etching agent according to the present invention has an enormous superiority in terms of industrial and global environmental perspectives.

### BRIEF DESCRIPTION OF THE DRAWINGS

[Fig. 1] A schematic view of an experimental device used in the present invention.
[Fig. 2] An illustration showing an opening formed in a silicon wafer by etching.

### MODE(S) FOR CARRYING OUT THE INVENTION

Hereinafter, a dry etching agent according to the present invention will be discussed in detail. Incidentally, the scope of the present invention is not limited to the following explanation, and modifications and variations of the following examples will occur within a range not affecting the light of the invention. In addition, any publication cited in the specification of the present application e.g. prior art documents, patent documents such as patent publications is involved in the specification as references.

A dry etching agent used in the present invention contains (A) the above-mentioned fluorine-containing unsaturated hydrocarbon represented by the formula [1] and the various gases (B) and (C) as discussed above (specifically discussed below).

The fluorine-containing unsaturated hydrocarbon represented by the formula [1] is not particularly limited insofar as it satisfies correlations defined by a, b and c, and concretely exemplified by 1,2,2-trifluoro-1-ethene (C₂F₃H), 1,1,3,3,3-pentafluoropropene (C₃F₅H), 1,2,3,3,3-pentafluoropropene (C₃F₅H), 1,1,2,3,3-pentafluoropropene (C₃F₅H), 1,1,1,3,4,4,4-heptafluoro-2-butene (C₄F₇H), 1,1,3,3,4,4,4-heptafluoro-1-butene (C₄F₇H), 1,2,3,3,4,4,4-heptafluoro-1-butene (C₄F₇H), 1,1,1,2,4,4,4-heptafluoro-2-butene (C₄F₇H), 1,1,1,4,4,5,5,5-octafluoro-2-pentene (C₅F₉H), 1,1,3,3,4,4,5,5,5-nonafluoro-1-pentene (C₅F₉H), 1,1,1,3,4,4,5,5,5-nonafluoro-2-pentene (C₅F₉H), 1,2,3,3,4,4,5,5,5-nonafluoro-1-pentene (C₅F₉H), 1,1,1,2,4,4,5,5,5-nonafluoro-2-pentene (C₅F₉H) and the like.

Of the above-mentioned fluorine-containing unsaturated hydrocarbons, compounds the carbon number of which is three or more sometimes include stereoisomers, i.e., a trans isomer (E isomer) and a cis isomer (Z-isomer). In the present invention, the fluorine-containing unsaturated hydrocarbon can be used in the form of either a trans isomer, a cis isomer or a mixture of trans and cis isomers.

Although any of the above-mentioned fluorine-containing unsaturated hydrocarbons will preferably be used in the present invention, it is preferable to use a compound having a relatively low carbon number in view of its productivity and availability, and more specifically, a compound that satisfies the formula [1] where a=2-4, b=3-7 and c=1 such as 1,2,2-trifluoro-1-ethene (C₂F₃H), 1,1,3,3,3-pentafluoropropene (C₃F₅H), 1,2,3,3,3-pentafluoropropene (C₃F₅H), 1,1,2,3,3-pentafluoropropene (C₃F₅H), 1,1,1,3,4,4,4-heptafluoro-2-butene (C₄F₇H), 1,1,3,3,4,4,4-heptafluoro-1-butene (C₄F₇H), 1,2,3,3,4,4,4-heptafluoro-1-butene (C₄F₇H), 1,1,1,2,4,4,4-heptafluoro-2-butene (C₄F₇H) and the like. Further, it is particularly preferable to use a compound that satisfies the formula [1] where a=3, b=5 and c=1 as will be discussed in the examples of the present application, such as 1,1,3,3,3-pentafluoropropene (C₃F₅H) and 1,2,3,3,3-pentafluoropropene (C₃F₅H).

The above-mentioned fluorine-containing unsaturated hydrocarbons may be prepared by any known conventional method. For example, 1,1,3,3,3-pentafluoropropene and 1,2,3,3,3-pentafluoropropene can be prepared by a method discussed in Japanese Patent Application Publications Nos. 2006-193437 and 2009-091301.

The fluorine-containing unsaturated hydrocarbon used in the present invention is characterized by having a double bond in the molecule, the double bond being linked to a trifluoromethyl group (CF₃) via a single bond, thereby allowing a double bond moiety thereof to be deposited by polymerization as well as allowing high-frequency generation of CF₃⁺ ions that are high in etching efficiency.

It is preferable that the F/C ratio (the abundance ratio of fluorine atoms to carbon atoms) of the etching agent is as close to 1 as possible in order to cause polymerization of carbon atoms in the etching agent and prevent a side wall of the etching target material from being subjected to nonselective etching.

The fluorine-containing unsaturated hydrocarbon used in the present invention has a small F/C ratio of 1.5 to 1.8 in the molecule and therefore considered to make it easier to protect the side wall of the etching target material by polymer deposition thereby improving the selectivity for anisotropic etching over isotropic etching by F radicals.

An etching method according to the present invention is applicable under various dry etching conditions. Various additives may be added to the etching agent depending on the physical properties, productivity, fine processing accuracy etc. of the etching target film.

Now the kind of each of the gases used together with the fluorine-containing unsaturated hydrocarbon represented by the formula [1] will be discussed.

The etching agent used in the present invention contains, each at a preferable vol%: (A) the fluorine-containing unsaturated hydrocarbon; (B) at least one kind of gas selected from the group consisting of O₂, O₃, CO, CO₂, COCl₂, COF₂, F₂, NF₃, Cl₂, Br₂, I₂, and YFₙ (where Y is Cl, Br or I and n is an integer of 1 to 5) (in this specification, these gases may be referred to as "an oxidizing gas", "an oxygen-containing gas" or "a halogen-containing gas"); and (C) at least one kind of gas selected from the group consisting of N₂, He, Ar, Ne, Xe, and Kr (in this specification, these gases may be referred to as "an inert gas").

The above-mentioned gas (B) is added for the purpose of increasing the etching rate for improvement in productivity. Among the above examples, O₂, CO and COF₂ are preferred for increase in metal etching rate. Particularly preferred is O₂. The addition of oxygen leads to selective acceleration of metal etching, that is, provides a significant increase in selectivity for etching of a metal relative to an oxide thereby allowing selective metal etching.

The amount of the oxidizing gas added is determined in accordance with the configuration and performance such as output etc. of the equipment and the characteristic properties of the etching target film. In general, the oxidizing gas is added in such a manner that the flow rate of the oxidizing gas is 1/10 to 30 times, preferably 1/10 to 20 times the flow rate of the fluorine-containing unsaturated hydrocarbon. If the flow rate of the oxidizing gas exceeds 30 times the flow rate of the fluorine-containing unsaturated hydrocarbon, the good anisotropic etching performance of the fluorine-containing unsaturated hydrocarbon may be impaired. If the flow rate of the oxidizing gas is less than 1/10 times the flow rate of the fluorine-containing unsaturated hydrocarbon, there may occur a significant increase in the amount of deposit caused by polymerization of the fluorine-containing unsaturated hydrocarbon.

The above-mentioned gas (C) is also usable as a diluent. In particular, the use of Ar leads to a higher etching rate by the synergistic effect with the fluorine-containing unsaturated hydrocarbon represented by the formula [1].

The amount of the inert gas added is determined in accordance with the configuration and performance such as output, exhaust capacity etc. of the equipment and the characteristic properties of the etching target film. The inert gas is preferably added in such a manner that the flow rate of the inert gas is 1 to 50 times the flow rate of the fluorine-containing unsaturated hydrocarbon.

Incidentally, each of the gases used in the present invention may be added in the form of a mixture of one or more kinds of the above-mentioned gases (B) and (C).

As mentioned above, it is one preferred embodiment of the present invention to contain the fluorine-containing unsaturated hydrocarbon represented by the formula [1], the oxidizing gas such as O₂ and the inert gas such as Ar in the dry etching agent. The preferred composition of the etching agent will be explained below in units of volume % assuming that the total of the volume % of the respective gases is 100 volume %.

In the case of bringing the fluorine-containing unsaturated hydrocarbon, the oxidizing gas and the inert gas into coexistence with one another, the volume % ratio of the unsaturated hydrocarbon, the oxidizing gas and the inert gas is preferably in the range of the unsaturated hydrocarbon:oxidizing gas:inert gas=1-45%:1-50%:5-98%, more preferably 4-40%:4-45%:15-92%.

For example, one particularly preferable embodiment as will be discussed below is that the dry etching agent contains cis-1,2,3,3,3-pentafluoropropene or 1,1,3,3,3-pentafluoropropene and an oxidizing gas and Ar gas respectively at a volume % ratio of 5-40%, 5-40% and 20-90%, because etching with low side etching ratio and high aspect ratio becomes feasible against various kinds of films.

When two or more kinds of oxidizing gases or inert gases are used in combination, the total volume ratio of the oxidizing gases or inert gases may be adjusted to within the above range.

Moreover, any gas selected from CF₄, CF₃H, CF₂H₂, CFH₃, C₂F₆, C₂F₄H₂, C₂F₅H, C₃F₈, C₃F₇H, C₃F₆H₂, C₃F₅H₃, C₃F₄H₄, C₃F₃H₅, C₃F₅H, C₃F₃H, C₃ClF₃H, C₄F₈, C₄F₆, C₅F₈, C₅F₁₀ etc. can suitably be added into the dry etching agent in order to change the F/C ratio of the etching gas. The amount of this gas compound added is favorably determined in such a manner as to change the F/C ratio without inhibiting selective etching and is preferably 0.01 to 2 times in volume the amount of the fluorine-containing unsaturated hydrocarbon.

Further, it is effective to add the reducing gas in order to reduce the amount of F radicals that accelerate isotropic etching. Specific examples of the reducing gas are CH₄, C₂H₂, C₂H₄, C₂H₆, C₃H₄, C₃H₆, C₃H₈, HF, HI, HBr, HCl, NO, NH₃ and H₂.

If the reducing gas is added in too large amount, there may occur a deterioration of productivity due to significant reduction of F radicals that work on etching. In particular, the addition of H₂ or C₂H₂ does not cause a change in etching rate of SiO₂ but causes a decrease in etching rate of Si so as to thereby increase the etching selectivity for selective etching of SiO₂ relative to the silicon substrate.

The dry etching method using the dry etching agent according to the present invention will be next described below in detail.

The dry etching agent according to the present invention can be applied for etching of various workpieces such as film layers of B, P, W, Si, Ti, V, Nb, Ta, Se, Te, Mo, Re, Os, Ru, Ir, Sb, Ge, Au, Ag, As, Cr and compounds thereof e.g. oxides, nitrides, carbides, fluorides, oxyfluorides, silicides, alloys etc. formed on substrates e.g. silicon wafer, metal plate, glass substrate, single crystal substrate or polycrystal substrate.

The dry etching agent can particularly effectively be applied to a semiconductor material. Specific examples of the semiconductor material are silicon-based materials such as silicon, silicon dioxide, silicon nitride, silicon carbide, silicon oxyfluoride and silicon oxycarbide, tungsten, rhenium and silicides thereof, titanium, titanium nitride, ruthenium, ruthenium silicide, ruthenium nitride, tantalum, tantalum oxide, tantalum oxyfluoride, hafnium, hafnium oxide, hafnium oxysilicide and hafnium zirconium oxide.

There is no particular limitation on the etching technique and reaction conditions in the dry etching method using the dry etching agent according to the present invention. There can be adopted various etching techniques such as reactive ion etching (RIE), electron cyclotron resonance (ECR) plasma etching and microwave etching. In the present invention, the dry etching method can be performed by generating plasma of the target propenes in the etching treatment equipment such that the generated plasma etches a given region of the workpiece placed in the equipment. For example, it is feasible to apply the dry etching method for manufacturing of semiconductor devices by forming a silicon oxide film or silicon nitride film on a silicon wafer, applying a resist with a given opening onto the silicon oxide film or silicon nitride film, and then, performing etching on the resist opening to remove therefrom some part of the silicon oxide film or silicon nitride film.

There is no particular limitation on the plasma generator used in the etching treatment. For example, there can preferably be used a high-frequency induction type plasma generator, a microwave type plasma generator etc.

During the etching treatment, the gas pressure is preferably 0.133 to 133 Pa for efficient anisotropic etching. If the gas pressure is lower than 0.133 Pa, the etching rate may be lowered. The resist selectivity may be impaired if the gas pressure exceeds 133 Pa.

The volumetric flow rate ratio of the fluorine-containing unsaturated hydrocarbon, the oxidizing gas and the inert gas during the etching treatment may be controlled to the same volume % ratio as mentioned above.

Further, the flow rate of the gases used depends on the size of the etching equipment and can be adjusted as appropriate by any skilled in the art in accordance with the etching equipment.

The temperature during the etching treatment is preferably 300°C or lower. It is particularly preferable to set the etching treatment temperature to be 240°C or lower for anisotropic etching. Under high-temperature conditions exceeding 300°C, there arises a strong tendency to cause isotropic etching so that required processing accuracy cannot be obtained. In addition, the resist is unfavorably significantly etched under such high-temperature conditions.

There is no particular limitation on the reaction time of the etching treatment. The reaction time is generally of the order of 5 to 30 minutes. As the reaction time depends on the status after the etching treatment, it is desirable to adjust the reaction time as appropriate while monitoring the progress of the etching treatment.

The selectivity of the etching agent for etching of silicon oxide film relative to silicon during contact-hole processing can be improved by adding the reducing gas as mentioned above and/or optimizing the gas pressure, flow rate, temperature etc. during the etching treatment.

### EXAMPLES

Hereinafter the present invention will specifically be explained with reference to examples; however, the present invention is not limited by these examples.

In Examples 1 to 12 as will be discussed below, a dry etching agent according to the present invention was applied for contact-hole processing to perform etching treatment on an interlayer dielectric film (Si02) or a silicon nitride film. In comparison, etching treatment was performed using CF₄ as a perfluorocarbon, F₂ or C₄F₆ (CF₂=CF-CF=CF₂) as a diolefin in Comparative Examples 1 to 12.

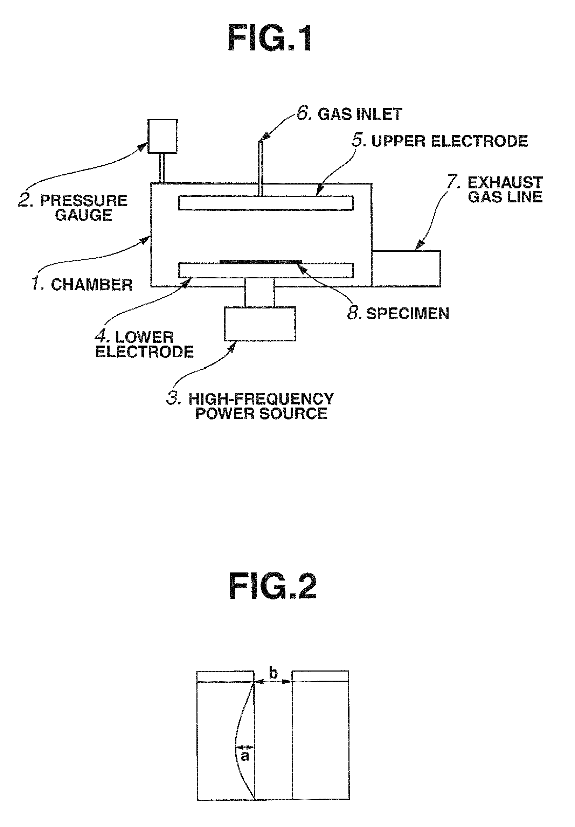

A schematic view of an experimental device used in the respective examples is shown in Fig. 1.

In the experimental device, a process gas was introduced into a chamber 1 through a gas inlet 6 that was connected to an upper electrode 5. Subsequently, the pressure inside the chamber 1 was set to 1 Pa. The process gas was then excited by means of a high-frequency power source 3 (13.56 MHz, 0.22 W/cm²), thereby generating active species. The generated active species were supplied to a specimen 8 that was placed on a lower electrode 4, such that the specimen 8 was etched by the active species.

Herein, the specimen 8 used was those prepared by forming a SiO₂ film or silicon nitride film of 5 µm thickness on a single crystal silicon wafer and applying a resist with an opening of 0.3 µm line width onto the film. The etching treatment was conducted for 30 minutes at a process pressure of 1 Pa with the use of a mixed gas containing C₄F₆, CF₄, F₂, cis-1,2,3,3,3-pentafluoropropene (hereinafter abbreviated as "1225ye(Z)") or 1,1,3,3,3-pentafluoropropene (hereinafter abbreviated as "1225zc") and oxygen, hydrogen or Ar, at gas flow rates shown in Table 1. After the etching treatment, the silicon wafer specimen was tested by SEM cross-sectional observation for comparison of the etching rate, the aspect ratio and the ratio of side etching (the amount of etching of the side wall) relative to the opening line width. The side etching ratio R (%) was determined by the following equation: R=(a/b)×100 as shown in Fig. 2.

The etching test results are indicated in Table 1.

**[Table 1]**

| | Kind of film | Etching gas | Etching gas flow rate | Oxygen flow rate | Hydrogen flow rate | Argon flow rate | Etching rate | Aspect ratio | Side etching ratio |
|---|---|---|---|---|---|---|---|---|---|
| | | | sccm | | | | nm/min | | R |
| Example 1 | SiO₂ | 1225yeZ | 15 | 35 | 0 | 500 | 105 | 6 | 1.60% |
| Example 2 | | | 30 | 20 | 0 | 500 | 123 | 7 or greater | <1% |
| Example 3 | | | 30 | 18 | 2 | 500 | 116 | | |
| Example 4 | Silicon nitride | | 15 | 35 | 0 | 500 | 58 | 6 | 1.30% |
| Example 5 | | | 30 | 20 | 0 | 500 | 53 | 7 or greater | <1% |
| Example 6 | | | 30 | 18 | 2 | 500 | 66 | | |
| Example 7 | SiO₂ | 1225zc | 15 | 35 | 0 | 500 | 108 | 6 | 1.50% |
| Example 8 | | | 30 | 20 | 0 | 500 | 131 | 7 or greater | <1% |
| Example 9 | | | 30 | 18 | 2 | 500 | 116 | | |
| Example 10 | Silicon nitride | | 15 | 35 | 0 | 500 | 42 | 6 | 1.20% |
| Example 11 | | | 30 | 20 | 0 | 500 | 40 | 7 or greater | <1% |
| Example 12 | | | 30 | 18 | 2 | 500 | 46 | | |
| Comparative Example 1 | SiO₂ | CF₄ | 25 | 25 | 0 | 500 | 97 | 5 | 4.00% |
| Comparative Example 2 | | | 20 | 30 | 0 | 500 | 104 | | 15.20% |
| Comparative Example 3 | Silicon nitride | | 25 | 25 | 0 | 500 | 95 | 3 | 5.60% |
| Comparative Example 4 | | | 20 | 30 | 0 | 500 | 99 | | 17.30% |
| Comparative Example 5 | SiO₂ | C₄F₆ | 25 | 25 | 0 | 500 | 84 | 6 | 2.00% |
| Comparative Example 6 | | | 20 | 30 | 0 | 500 | 88 | | 6.00% |
| Comparative Example 7 | Silicon nitride | | 25 | 25 | 0 | 500 | 65 | 4 | 5.20% |
| Comparative Example 8 | | | 20 | 30 | 0 | 500 | 71 | | 8.40% |
| Comparative Example 9 | SiO₂ | F₂ | 45 | 5 | 0 | 500 | 235 | 3 | 35.20% |
| Comparative Example 10 | Silicon nitride | | 45 | 5 | 0 | 500 | 294 | 2 | 46.50% |
| Comparative Example 11 | SiO₂ | C₄F₆ | 25 | 23 | 2 | 500 | 61 | 3 | 3.20% |
| Comparative Example 12 | Silicon nitride | | 20 | 25 | 5 | 500 | 61 | 4 | 9.50% |

It was found from the results of Examples 1, 2, 3, 7, 8 and 9 that the dry etching agent according to the present invention exhibited on SiO₂ high aspect ratio, low side etching ratio and good contact-hole processing shape as compared with CF₄, C₄F₆, and F₂ used in Comparative Examples 1, 2, 5, 6, 9 and 11.

It was found from the results of Examples 4, 5, 6, 10, 11 and 12 that the dry etching agent according to the present invention exhibited on silicon nitride high aspect ratio, low side etching ratio and good contact-hole processing shape as compared with CF₄, C₄F₆, and F₂ used in Comparative Examples 3, 4, 7, 8, 10 and 12.

The etching test was conducted also on a specimen with an opening of 0.1 µm line width under the same conditions as in the above-mentioned examples, thereby obtaining a result similar to the above.

It was found from the results of Examples 1 to 12 that the dry etching agent according to the present invention exhibited high aspect ratio, low side etching ratio and good contact-hole processing shape as compared with conventional etching gases such as CF₄ and C₄F₆, and F₂ used in Comparative Examples 1 to 12.

### INDUSTRIAL APPLICABILITY

An agent containing pentafluoropropene, i.e., a target agent of the present invention may be used as a dry etching agent. Furthermore, an etching method using the same may be applied to a semiconductor manufacturing method.

### EXPLANATION OF REFERENCE NUMERALS

[Fig. 1]
   1 Chamber
   2 Pressure Gauge
   3 High-frequency Power Source
   4 Lower Electrode
   5 Upper Electrode
   6 Gas Inlet
   7 Exhaust Gas Line
   8 Specimen
[Fig. 2]
   a Amount of etching of side wall
   b Opening line width

## Claims

1. A dry etching agent comprising:
(A) a fluorine-containing unsaturated hydrocarbon represented by the formula [1]
CₐF_{b}H_{c} [1]
(In the formula [1], a, b and c are each positive integers and satisfy the correlations of 2≤a≤5, c<b≥1, 2a+2>b+c and b≤a+c, excluding the case where a=3, b=4 or c=2.);
(B) at least one kind of gas selected from the group consisting of O₂, O₃, CO, CO₂, COCl₂, COF₂, F₂, NF₃, Cl₂, Br₂, I₂, and YFₙ (where Y is Cl, Br or I and n is an integer of 1 to 5); and
(C) at least one kind of gas selected from the group consisting of N₂, He, Ar, Ne, Xe, and Kr,
wherein volume percentages of (A), (B) and (C) are 5-40 %, 5-40 % and 20-90 %, respectively (where the total of each of the volume percentages is 100 %).

2. A dry etching agent as claimed in claim 1, wherein the fluorine-containing unsaturated hydrocarbon is 1,2,3,3,3-pentafluoropropene or 1,1,3,3,3-pentafluoropropene.

3. A dry etching agent as claimed in claim 1 or 2, wherein the reducing gas further comprises at least one kind of gas selected from the group consisting of H₂, CH₄, C₂H₂, C₂H₄, C₂H₆, C₃H₄, C₃H₆, C₃H₈, HF, HI, HBr, HCl, CO, NO and NH₃.

4. A dry etching agent as claimed in any of claims 1 to 3, further comprising at least one kind of gas selected from the group consisting of CF₄, CF₃H, CF₂H₂, CFH₃, C₂F₆, C₂F₄H₂, C₂F₅H, C₃F₈, C₃F₇H, C₃F₆H₂, C₃F₅H₃, C₃F₄H₄, C₃F₃H₅, C₃F₅H, C₃F₃H, C₃ClF₃H, C₄F₈, C₄F₆, C₅F₈ and C₅F₁₀.

5. A dry etching method for selectively etching at least one kind of silicon-based material selected from the group consisting of silicon dioxide, silicon nitride, polycrystalline silicon, amorphous silicon and silicon carbide, comprising the steps of:
generating a plasma gas from a dry etching agent as claimed in any of claims 1 to 4; and
using the plasma gas.

6. A dry etching method for selectively etching at least one kind of silicon-based material selected from the group consisting of silicon dioxide, silicon nitride, polycrystalline silicon, amorphous silicon and silicon carbide, comprising the steps of:
using (A) 1,2,3,3,3-pentafluoropropene, (B) at least one or more kinds of gas selected from the group consisting of H₂, O₂, CO and COF₂, and Ar,
wherein (A), (B) and Ar are fed at volumetric flow rate ratios of 5-40 %, 5-40 % and 20-90 %, respectively (where the total of each of the volumetric flow rate ratios is 100 %).

7. A dry etching method for selectively etching at least one kind of silicon-based material selected from the group consisting of silicon dioxide, silicon nitride, polycrystalline silicon, amorphous silicon and silicon carbide, comprising the steps of:
using (A) 1,1,3,3,3-pentafluoropropene, (B) at least one or more kinds of gas selected from the group consisting of H₂, O₂, CO and COF₂, and Ar,
wherein (A), (B) and Ar are fed at volumetric flow rate ratios of 5-40 %, 5-40 % and 20-90 %, respectively (where the total of each of the volumetric flow rate ratios is 100 %).
